# EUROPÄISCHE PATENTSCHRIFT

(11) **EP 3 997 469 B1**
(45) Veröffentlichungstag und Bekanntmachung des Hinweises auf die Patenterteilung: **02.08.2023**
(21) Anmeldenummer: 20764028.5
(22) Anmeldetag: 17.08.2020
(51) Int. Cl.: G01R 31/12, G01R 31/34

(54) **ERFASSEN EINER TEILENTLADUNG**
DETECTION OF PARTIAL DISCHARGE
DÉTECTION D'UNE DÉCHARGE PARTIELLE

(30) Priorität: 19.09.2019 EP 19198375
(43) Veröffentlichungstag der Anmeldung: 18.05.2022
(73) Patentinhaber: Siemens Aktiengesellschaft, 80333 München (DE)
(72) Erfinder: BORMANN, Ulf, 90518 Altdorf (DE); MEYER, Martin, 90425 Nürnberg (DE); SCHEIBNER, Dirk, 90473 Nürnberg (DE); SCHIMMER, Jürgen, 90473 Nürnberg (DE); WIEGAND, Hermann-Josef, 36169 Rasdorf (DE)
(74) Vertreter: Siemens Patent Attorneys
(86) Internationale Anmeldenummer: PCT/EP2020/072944
(87) Internationale Veröffentlichungsnummer: WO 2021/052692

(56) Entgegenhaltungen:
- US-A1- 2007 057 677
- US-A1- 2018 120 380

## Beschreibung

Die Erfindung betrifft die Erfassung von Teilentladungen an einer Wicklung einer elektrischen Maschine.

Teilentladungen sind lokale elektrische Entladungen, welche beispielsweise in lokalen Inhomogenitäten des Isolationsmaterials, beispielsweise in kleinen Lufteinschlüssen innerhalb der Isolierung einer elektrischen Leitung infolge starker Inhomogenitäten eines elektrischen Feldes verursacht werden. Teilentladungen können eine Isolierung lokal beschädigen und langfristig zum Versagen der Isolierung führen. Deshalb werden insbesondere elektrische Maschinen regelmäßig auf Teilentladungen untersucht. Teilentladungen verursachen kurze elektromagnetische Pulse mit einer typischen Dauer von weniger als 1 ps und Frequenzanteilen bis weit in den UHF-Frequenzbereich. Üblicherweise wird nach Teilentladungssignalen in Frequenzbereichen zwischen etwa 100 kHz und 10 MHz gesucht, in denen Teilentladungspulse in der Regel am stärksten sind.

Für die Erfassung von Teilentladungen gibt es eine Vielzahl von teilweise, beispielsweise nach DIN EN 60270, genormten Messverfahren. An elektrischen Maschinen werden fast ausschließlich Offline-Messungen durchgeführt, bei denen der reguläre Betrieb der elektrischen Maschine unterbrochen wird und hohe Kosten entstehen, beispielsweise durch die Betriebsunterbrechungen und die Kosten für die Messgeräte. Solche Messungen können deshalb nur gelegentlich durchgeführt werden.

Bei den Offline-Messungen kann der Messaufbau in einem definierten Umfeld durchgeführt werden und externe Störeinflüsse können oft (aber nicht immer) weitgehend ausgeschlossen werden. Bei Online-Messungen während des regulären Betriebs einer elektrischen Maschine sind dagegen alle Betriebskomponenten aktiv und können diese Messungen durch Einkopplung von Störsignalen beeinflussen. Wenn eine rotierende elektrische Maschine beispielsweise an einem Stromrichter betrieben wird, werden Teilentladungspulse von einer Vielzahl von Störsignalen überlagert, die von den Schaltvorgängen des Stromrichters verursacht werden. Als weitere Störquellen kommen beispielsweise Funkdienste wie Rundfunk, Betriebsfunk oder Mobilfunk, unspezifische EMV-Störquellen, nicht zugelassene Funkgeräte, in ISM-Bändern arbeitende Geräte (z.B. Hochfrequenzschweißgeräte, Lasergeräte), Funkschüsseln, Alarmanlagen und/oder Funkschalter in Frage. Welche Störsignale auftreten können und welche Frequenzen diese Störsignale haben, hängt von den spezifischen Eigenschaften der Komponenten des Objekts ab, in dem Teilentladungen erfasst werden sollen (beispielsweise von Komponenten eines Systems aus Stromrichter und elektrischer Maschine), sowie von in der Umgebung des Objekts vorhandenen Störquellen.

In industriellen Anlagen treten häufig Störungen durch benachbarte Maschinen am Umrichter auf. Das kann ein dauerhaftes Problem darstellen. Schweißarbeiten in der Umgebung können auch eine Störquelle sein. Bei Reparaturarbeiten ist das jedoch nur eine temporäre Störung, im Falle von Schweißrobotern jedoch auch eine dauerhafte. Bei Störsignalen handelt sich insbesondere um impulsartige Störungen mit einem breiten Spektrum bis in den MHz bzw. 100-MHz-Bereich. Der Frequenzbereich hängt dabei von der Störquelle ab.

Für die zuverlässige Erfassung von Teilentladungen müssen derartige Störsignale von den Teilentladungssignalen getrennt beziehungsweise unterschieden werden, um Teilentladungssignale nicht mit Störsignalen zu verwechseln.

Aus der US2007057677A1 ist eine Vorrichtung und ein Verfahren zum Auffinden von Teilentladungen in einem Leiterstab einer dynamoelektrischen Maschine bekannt, wobei der Leiterstab mit einer äußeren elektrischen Isolierung versehen ist. Ein erster und ein zweiter Sensor ist dazu ausgebildet, ein von der Teilentladung erzeugtes Signal zu erfassen, das sich entlang des Leiterstabes ausbreitet. Der erste und der zweite Sensor sind am Leiterstab beabstandet angeordnet, um ein Teilentladungs-Ausgangssignal abzugeben, das einen bestimmten Erfassungszeitpunkt repräsentiert. Die Teilentladungs-Ausgangssignale des ersten und zweiten Sensors werden einer Auswerteeinheit zugeführt, die so ausgebildet ist, dass sie die Teilentladung auf dem Leiterstab lokalisiert.

Aus der US2018120380A1 ist eine Überwachungsvorrichtung zum Überwachen der Teilentladungsaktivität in einem elektrischen Wechselstromsystem bekannt. Die Vorrichtung weist Folgendes auf: Ein Paar von Hoch- und Niederfrequenzsensoren, ein Zeitsteuermodul, das so angeordnet ist, dass es ein zyklisches Signal von dem Niederfrequenzsensor empfängt und ein Zeitsteuersignal liefert, das von der Zeitgebung aufeinanderfolgender Zyklen des zyklischen Signals abgeleitet wird; und eine Überwachungseinheit, die angeordnet ist, um ein Signal von dem Hochfrequenzsensor zu digitalisieren, um das digitalisierte Signal als aufeinanderfolgende Datenblöcke unterschiedlicher Dauer zu erfassen und um die Erfassung jedes Datenblocks als Reaktion auf das Taktsignal auszulösen. Ein elektrisches System mit Zustandsüberwachung umfasst einen drehzahlgeregelten Antrieb und einen vom Antrieb betriebenen Motor, mit einem Paar von Sensoren.

Der Erfindung liegt die Aufgabe zugrunde, die Erfassung von Teilentladungen an einer Wicklung einer elektrischen Maschine insbesondere hinsichtlich der Unterscheidung zwischen Teilentladungssignalen und Störsignalen zu verbessern.

Die Aufgabe wird erfindungsgemäß durch ein Verfahren mit den Merkmalen des Anspruchs 1 und eine Vorrichtung mit den Merkmalen des Anspruchs 11 gelöst.

Vorteilhafte Ausgestaltungen der Erfindung sind Gegenstand der Unteransprüche.

Bei dem erfindungsgemäßen Verfahren zum Erfassen einer Teilentladung an einer Wicklung einer elektrischen Maschine werden in einem Teilentladungsfrequenzbereich elektromagnetische erste Messsignale und in einem Störfrequenzbereich elektromagnetische zweite Messsignale erfasst. Ferner wird ein Zeitfenster um ein erstes Messsignal vorgegeben und es werden ein Erkennungskriterium für ein Teilentladungssignal und ein Störsignalkriterium für ein zweites Messsignal definiert.

Teilentladungen können an verschiedenen Stellen wie Nut oder Wickelkopf auftreten. Die verschiedenen Typen weisen im phasenaufgelösten Teilentladungs-Plot unterschiedliche Muster auf. Das Zeitfenster kann insbesondere an das erwartete angepasst sein bzw. werden.

TE-Impulse besitzen in der Regel eine Dauer von ca. 100ns bis kürzer als 5us. Das Zeitfenster kann in einer Ausführungsform kürzer als 5us vor und nach dem Impuls gelegt sein.

Auf eine Teilentladung wird geschlossen, wenn ein erstes Messsignal erfasst wird, das das Erkennungskriterium erfüllt, und in dem Zeitfenster um das erste Messsignal kein zweites Messsignal erfasst wird, das das Störsignalkriterium erfüllt.

Erfindungsgemäß werden also neben elektromagnetischen Messsignalen zum Erfassen von Teilentladungen, die hier als erste Messsignale bezeichnet werden, weitere elektromagnetische Messsignale erfasst, die hier als zweite Messsignale bezeichnet werden und mit denen Störsignale detektiert werden, die die ersten Messsignale beeinflussen oder sogar erzeugen könnten.

In einer nicht erfindungsgemäßen Ausgestaltung kann das zweite Messignal auch ein Signal sein, welches kein elektromagnetisches Signal ist. Dies kann beispielsweise bei einem benachbarten Motor am Umrichter ausgeführt sein, indem man dort den Körperschall misst und über den Körperschall die Umrichtertakte detektiert. Allerdings ist dabei die Laufzeit im Maschinengehäuse zu beachten. Der Körperschallimpuls kommt viel später am Sensor an als die elektrische Störung am Teilentladungssensor. In einer weiteren Ausgestaltung wird z.B. ein Ansteuersignal der Leistungshalbleiter des Umrichters direkt zur Störaustastung verwendet, also als zweites Messignal, wobei dieses wieder ein elektrisches oder - nicht erfindungsgemäß-ein optisches Signal sein kann.

Um erste Messsignale als Kandidaten für Teilentladungssignale zu identifizieren, wird deren Erfassung auf einen für Teilentladungen typischen Teilentladungsfrequenzbereich beschränkt und es wird ein Erkennungskriterium definiert, das ein erstes Messsignal erfüllen muss, um als Kandidat für ein Teilentladungssignal eingestuft zu werden. Die zweiten Messsignale werden in einem Störfrequenzbereich erfasst, der für Störsignale relevant ist, die die ersten Messsignale beeinflussen oder erzeugen könnten.

Ferner wird insbesondere ein Störsignalkriterium definiert, das ein zweites Messsignal als potentiell relevantes Störsignal für die Teilentladungserfassung charakterisiert. Zur Auswertung der zweiten Messsignale wird ein Zeitfenster um ein erfasstes erstes Messsignal vorgegeben, in dem nach für die Teilentladungserfassung relevanten Störsignalen gesucht wird, wenn das erste Messsignal mittels des Erkennungskriteriums als ein Kandidat für ein Teilentladungssignal eingestuft wird. Dadurch wird berücksichtigt, dass ein erstes Messsignal nur durch Störungen beeinflusst oder erzeugt werden kann, die kurz vor der Erfassung des ersten Messsignals auftreten (insbesondere wenige ps), so dass für die Teilentladungserfassung nur Störsignale relevant sind, die zeitlich mit dem ersten Messsignal wenigstens annähernd zusammenfallen.

In einer Ausgestaltung kann die Größe des Zeitfensters festgelegt werden, bzw. verändert werden. Dabei ist beispielsweise der Abstand der Antennen, also der Einfluss der Signallaufzeit im Ausbreitungsmedium und die zeitliche Toleranz der Impulserfassung (Jitter), zu beachten. Das Zeitfenster ist größer als diese Faktoren zu wählen.

In einer Ausgestaltung wird der Anfang und/oder das Ende des ersten erfassten Messsignals über eine Amplituden-Schwelle festgestellt, wobei die Erkennung mittels Komparators möglich ist.

Das Zeitfenster berücksichtigt beispielsweise Zeitdauern, die zwischen der Ursache und dem Erfassen eines ersten Messsignals und/oder eines zweiten Messsignals und/oder für ein Bearbeiten eines ersten Messsignals und/oder eines zweiten Messsignals vergehen. Erfindungsgemäß wird daher auf eine Teilentladung geschlossen, wenn ein erstes Messsignal erfasst wird, das als ein Kandidat für ein Teilentladungssignal eingestuft wird, und in dem Zeitfenster um dieses erste Messsignal kein relevantes Störsignal erfasst wird. Die gleichzeitige Auswertung eines ersten Messsignals und von Störsignalen, die das erste Messsignal potentiell beeinflussen und erzeugen können, erhöht vorteilhaft die Zuverlässigkeit der Erkennung einer Teilentladung gegenüber einer Auswertung nur des ersten Messsignals. Die Beeinflussung betrifft insbesondere eine Überlagerung von Signalen.

Eine Ausgestaltung der Erfindung sieht vor, dass das Erkennungskriterium wenigstens ein Merkmal eines Amplitudensignals für Amplituden von Spektralanteilen eines ersten Messsignals in Abhängigkeit von einer Frequenz der Spektralanteile umfasst. Beispielsweise ist das Amplitudensignal ein Hüllkurvensignal, das zum Verlauf logarithmierter Amplituden von Spektralkomponenten der Ausgangssignale des Frequenzfilters proportional ist. Diese Ausgestaltung der Erfindung vereinfacht vorteilhaft die Auswertung eines ersten Messignals, da Teilentladungssignale hochfrequente Signale sind, deren direkte Auswertung aufwändig ist und viel Rechenperformance erfordert. Geeignete Merkmale zur Definition des Erkennungskriteriums sind beispielsweise Schranken für eine Pulsdauer und/oder eine Pegelhöhe des Amplitudensignals und/oder ein die Signalform des Amplitudensignals charakterisierendes Merkmal (beispielsweise eine Schranke für ein Verhältnis der Pegelhöhe zu der Pulsdauer). Störsignale (z.B. durch benachbarten Umrichter) treten häufig periodisch und mit hoher Wiederholfrequenz auf.

Entsprechend sieht eine weitere Ausgestaltung der Erfindung vor, dass das Störsignalkriterium wenigstens ein Merkmal eines Amplitudensignals für Amplituden von Spektralanteilen eines zweiten Messsignals in Abhängigkeit von einer Frequenz der Spektralanteile umfasst.

Als Erkennungskriterium kann z.B. die Wiederholfrequenz verwendet werden. Die Bandbreite der TE-Rate bei guter Isolation von <100 Impulse/s bis hin zu geschädigter Isolation >100K Impulse/s kann groß sein. Strenge Periodizität ist ein Merkmal, das auf einen Störer hinweist. Das kann durch statistische Merkmale erkannt werden. Als ein Kriterium kann auch eine Auswertung der Verteilung des Zeitabstands benachbarter Impulse dienen. Weiterhin können nicht nur direkte Impulse, sondern mehrere benachbarte Impulse und eine spektrale Auswertung und/oder eine Autokorrelation, insbesondere mit einer vermuteten Störfrequenz beim Erkennungskriterium, berücksichtigt sein.

Bei einer weiteren Ausgestaltung der Erfindung wird geprüft, ob zweite Messsignale eine Signalfolge sich regelmäßig, beispielsweise in gleichen Zeitabständen, wiederholender gleichartiger Signale bilden, und das Störsignalkriterium die Zugehörigkeit eines zweiten Messsignals zu einer derartigen Signalfolge umfasst. Diese Ausgestaltung der Erfindung berücksichtigt, dass Störsignale häufig periodisch erzeugt werden, während Teilentladungssignale in der Regel zufallsverteilt auftreten.

Bei einer weiteren Ausgestaltung der Erfindung weisen der Teilentladungsfrequenzbereich und der Störfrequenzbereich eine nichtleere Schnittmenge auf. Dadurch werden vorteilhaft insbesondere zweite Messsignale berücksichtigt, die Frequenzen in dem Teilentladungsfrequenzbereich aufweisen und deshalb potentiell relevant für die Teilentladungserfassung sind.

Wenn Störsignale periodisch auftreten und/oder ein bestimmtes Muster aufweisen, kann in einer Ausgestaltung, zur Erkennung der Signale, eine KI eingesetzt werden. Aus der statistischen Auswertung der zeitlichen Folge lassen sich beispielsweise Merkmale ableiten, die eine Klassifizierung der Impulse in TE (Teilentladung) und Störung erlauben. Insbesondere kann eine Art PLL, die sich auf das Störsignal einloggt, verwendet werden. Weisen bestimmte Störer charakteristische Impulsmuster auf, können diese durch eine Mustererkennung detektiert werden.

Bei einer weiteren Ausgestaltung der Erfindung wird wenigstens eine Teilmenge der ersten Messsignale in oder an einer Isolation der Wicklung der elektrischen Maschine erfasst. Diese Ausgestaltung der Erfindung ermöglicht vorteilhaft eine Erfassung erster Messsignale in der Nähe der Entstehung der zu erfassenden Teilentladungen und verbessert dadurch die Messempfindlichkeit der Teilentladungserfassung. Außerdem werden die Einflüsse von Störsignalen auf die ersten Messsignale reduziert, da Störsignale in der Regel außerhalb der elektrischen Maschine erzeugt werden.

Bei einer weiteren Ausgestaltung der Erfindung wird wenigstens eine Teilmenge der zweiten Messsignale außerhalb der elektrischen Maschine, insbesondere in der Nähe einer zweite Messsignale potentiell erzeugenden Störquelle, erfasst. Wie bereits erwähnt wurde, werden Störsignale in der Regel außerhalb der elektrischen Maschine erzeugt. Daher ist eine Erfassung zweiter Messsignale außerhalb der elektrischen Maschine, insbesondere in der Nähe potentieller Störquellen, vorteilhaft, um eine hohe Messempfindlichkeit der Erfassung von Störsignalen zu erreichen. Insbesondere kann vorgesehen sein, vorab potentielle Störquellen zu ermitteln, zu orten und soweit möglich zu eliminieren und zweite Messsignale gezielt in der Nähe von georteten Störquellen zu erfassen, die nicht eliminiert werden können.

Der Ort der Erfassung von Störsignalen bzw. Teilentladungssignalen kann eine Rolle spielen. Der Stromrichter ist eine potentielle Quelle. Deshalb ist insbesondere die Anordnung von Sensoren zur Messung der Signale nahe am Stromrichter und/oder an der vom Stromrichter versorgten Maschine günstig. Nahe bedeutet dabei insbesondere im Bereich der ersten 15% der Kabellänge des Kabels, an dem die Messung vorgenommen wird.

Bei einer weiteren Ausgestaltung der Erfindung wird ein Unterscheidungskriterium zum Unterscheiden eines ersten Messsignals von einem zweiten Messsignal definiert. Ferner wird im Fall, dass in dem Zeitfenster um ein erstes Messsignal, das das Erkennungskriterium erfüllt, ein zweites Messsignal, das das Störsignalkriterium erfüllt, erfasst wird, das erste Messsignal mit dem zweiten Messsignal verglichen und es wird nur dann auf eine Teilentladung geschlossen, wenn das erste Messsignal das Unterscheidungskriterium erfüllt. Diese Ausgestaltung der Erfindung zielt also auf die Situation, dass in dem Zeitfenster um ein erstes Messsignal, das als ein Kandidat für ein Teilentladungssignal eingestuft wird, ein zweites Messsignal erfasst wird, das ein für die Teilentladungserfassung potentiell relevantes Störsignal ist. Die Ausgestaltung der Erfindung sieht vor, in einem solchen Fall das erste und das zweite Messsignal miteinander zu vergleichen, um zu entscheiden, ob das erste Messsignal auf eine Teilentladung oder auf eine Störquelle zurückgeht. Um dies zu entscheiden, wird ein Unterscheidungskriterium zum Unterscheiden eines ersten Messsignals von einem zweiten Messsignal definiert und verwendet.

Eine Weitergestaltung der vorgenannten Ausgestaltung der Erfindung sieht vor, dass das Unterscheidungskriterium wenigstens ein Merkmal umfasst, das Amplitudensignale für Amplituden von Spektralanteilen eines ersten Messsignals und eines zweiten Messsignals in Abhängigkeit von einer Frequenz der Spektralanteile voneinander unterscheidet. Eine weitere Weitergestaltung sieht vor, dass das Unterscheidungskriterium das Fehlen einer periodischen Wiederholung des ersten Messsignals umfasst, die für das zweite Messsignal charakteristisch ist. Die erste Weitergestaltung sieht den Vergleich eines ersten Messsignals und eines zweiten Messsignals anhand des Vergleichs von aus ihnen gebildeten Amplitudensignalen vor. Dies hat den oben bereits erwähnten Vorteil der gegenüber einer direkten Auswertung der Messsignale vereinfachten Auswertbarkeit der Amplitudensignale. Die zweite Weitergestaltung nutzt wiederum aus, dass Störsignale häufig periodisch erzeugt werden, während Teilentladungssignale in der Regel zufallsverteilt auftreten. Daher ist es unwahrscheinlich, dass das erste Messsignal auf ein Störsignal zurückgeht, wenn sich das zweite Messsignal periodisch wiederholt, während das erste Messsignal sich nicht periodisch wiederholt.

Bei einer weiteren Ausgestaltung der Erfindung umfasst das Störsignalkriterium einen Schwellenwert für eine Signalstärke eines zweiten Messsignals und die Auswertung von ersten Messsignalen wird unterbrochen, wenn die Signalstärke eines zweiten Messsignals den Schwellenwert überschreitet. Gemäß dieser Ausgestaltung der Erfindung wird die Auswertung von ersten Messsignalen also bei dem Auftreten sehr starker Störsignale unterbrochen, da sehr starke Störsignale eine Beeinflussung von Teilentladungssignalen wahrscheinlich machen und somit die Aussagekraft einer Auswertung erster Messsignale in Frage stellen. Der Schwellenwert ist dabei vorzugsweise veränderbar und somit insbesondere sich ändernden Umständen und Anforderungen der Teilentladungserfassung anpassbar.

Bei einer weiteren Ausgestaltung der Erfindung kann vorgesehen sein, dass die erfassten zweiten Messsignale ausgewertet werden, um gezielt nach die Teilentladungsmessungen beeinflussenden Störquellen zu suchen, um diese soweit wie möglich zu eliminieren. Ferner kann vorgesehen sein, anhand der Häufigkeit und/oder wenigstens eines weiteren Kennwerts zweiter Messsignale (beispielsweise der Zeitpunkte des Auftretens, der Signalstärken und/oder Signaldauern zweiter Messsignale) die Teilentladungserfassung hinsichtlich ihrer Güte beziehungsweise Zuverlässigkeit zu bewerten. So wird die Güte der Teilentladungserfassung umso schlechter eingestuft, je größer die Häufigkeit und/oder Stärke mit den ersten Messsignalen zeitlich korrelierter zweiter Messignale ist.

Eine erfindungsgemäße Vorrichtung zum Erfassen einer Teilentladung an einer Wicklung einer elektrischen Maschine gemäß dem erfindungsgemäßen Verfahren umfasst zwei Messanordnungen und wenigstens eine Auswerteeinheit. Eine erste Messanordnung ist eingerichtet, die ersten elektromagnetischen Messsignale zu erfassen. Die zweite Messanordnung ist eingerichtet, die zweiten elektromagnetischen Messsignale zu erfassen. Die wenigstens eine Auswerteeinheit ist eingerichtet, zu prüfen, ob ein erstes Messsignal das Erkennungskriterium für ein Teilentladungssignal erfüllt, und ob in dem vorgegebenen Zeitfenster um ein erstes Messsignal ein zweites Messsignal erfasst wird, das das Störsignalkriterium erfüllt.

Bei einer Ausgestaltung der erfindungsgemäßen Vorrichtung weist die erste Messanordnung wenigstens eine in oder an einer Isolation der Wicklung der elektrischen Maschine angeordnete erste Antenne und für jede erste Antenne eine Auskoppeleinheit zum Auskoppeln von der ersten Antenne erfasster Signale auf.

Bei einer weiteren Ausgestaltung der erfindungsgemäßen Vorrichtung weist die zweite Messanordnung wenigstens eine außerhalb der elektrischen Maschine, insbesondere in der Nähe einer zweite Messsignale potentiell erzeugenden Störquelle, angeordnete zweite Antenne und für jede zweite Antenne eine Auskoppeleinheit zum Auskoppeln von der zweiten Antenne erfasster Signale auf.

Insbesondere können erste und/oder zweite Messsignale an verschiedenen Orten, beispielsweise mit mehreren Antennen, erfasst werden.

Bei einer weiteren Ausgestaltung der erfindungsgemäßen Vorrichtung ist die wenigstens eine Auswerteeinheit eingerichtet, im Fall, dass in dem Zeitfenster um ein erstes Messsignal, das das Erkennungskriterium erfüllt, ein zweites Messsignal, das das Störsignalkriterium erfüllt, erfasst wird, das erste Messsignal mit dem zweiten Messsignal auf der Basis eines Unterscheidungskriteriums zu vergleichen.

Bei einer weiteren Ausgestaltung der erfindungsgemäßen Vorrichtung ist die wenigstens eine Auswerteeinheit eingerichtet, die Auswertung von ersten Messsignalen zu unterbrechen, wenn die Signalstärke eines zweiten Messsignals einen Schwellenwert überschreitet.

Eine erfindungsgemäße Vorrichtung ermöglicht die Durchführung des erfindungsgemäßen Verfahrens mit den oben bereits genannten Vorteilen.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
- FIG 1: ein Blockdiagramm eines ersten Ausführungsbeispiels einer Vorrichtung zum Erfassen einer Teilentladung,
- FIG 2: ein Blockdiagramm eines zweiten Ausführungsbeispiels einer Vorrichtung zum Erfassen einer Teilentladung,
- FIG 3: ein Ablaufdiagramm eines Ausführungsbeispiels eines Verfahrens zum Erfassen einer Teilentladung.

Einander entsprechende Teile sind in den Figuren mit denselben Bezugszeichen versehen.

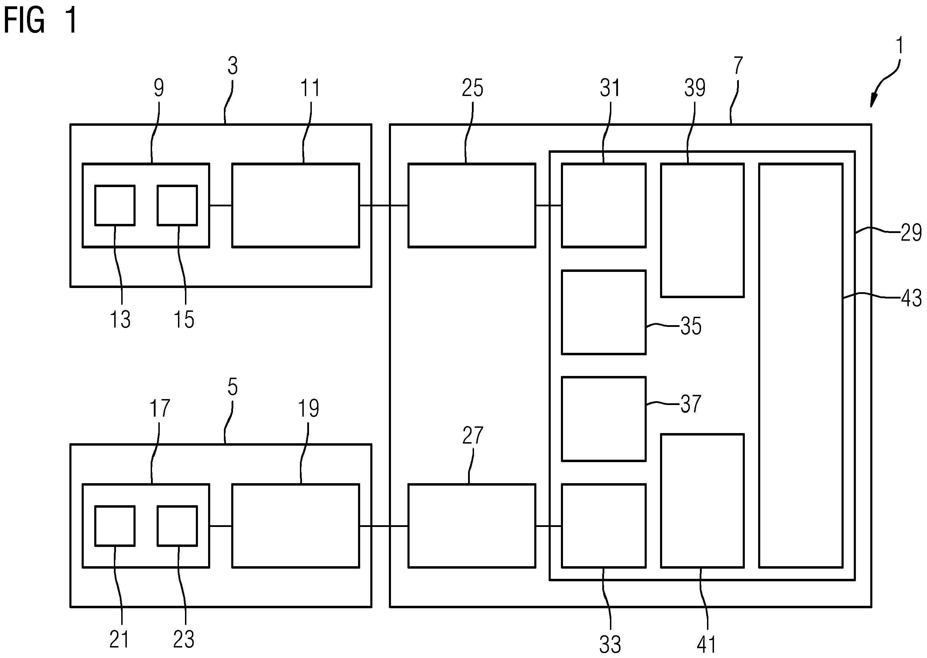

FIG 1 zeigt ein Blockdiagramm eines ersten Ausführungsbeispiels einer Vorrichtung 1 zum Erfassen einer Teilentladung an einer Wicklung einer elektrischen Maschine. Die Vorrichtung 1 umfasst zwei Messanordnungen 3, 5 und eine Auswerteeinheit 7.

Eine erste Messanordnung 3 ist eingerichtet, in einem Teilentladungsfrequenzbereich erste elektromagnetische Messsignale zu erfassen. Dazu weist die erste Messanordnung 3 eine erste Sensoreinheit 9 und ein erstes Frequenzfilter 11 auf. Die erste Sensoreinheit 9 weist eine in oder an einer Isolation der Wicklung der elektrischen Maschine angeordnete erste Antenne 13 und eine erste Auskoppeleinheit 15 zum Auskoppeln von der ersten Antenne 13 erfasster Signale auf. Die erste Antenne 13 wird beispielsweise von Zuleitungen eines ersten Temperatursensors gebildet, welcher zum Erfassen einer Temperatur in der elektrischen Maschine eingerichtet ist und dazu einen temperaturabhängigen Messwiderstand aufweist, der beispielsweise aus Platin hergestellt ist, beispielsweise einen Platin-Messwiderstand Pt100. Derartige Temperatursensoren werden häufig ohnehin in elektrischen Maschinen verwendet und können so vorteilhaft auch zur Teilentladungserfassung genutzt werden. Vorzugsweise sind Anschlussleiter der ersten Antenne 13 geschirmt ausgeführt, um Einkopplungen von Störsignalen zu reduzieren. Die erste Auskoppeleinheit 15 ist beispielsweise eine Frequenzweiche zum Auskoppeln von der ersten Antenne 13 erfasster hochfrequenter Signale, um diese Signale von niederfrequenten Temperatursignalen zu trennen, die von dem ersten Temperatursensor erfasst werden. Das erste Frequenzfilter 11 ist eingerichtet, die von der ersten Auskoppeleinheit 15 ausgekoppelten elektrischen Signale zu filtern, und weist einen den Teilentladungsfrequenzbereich definierenden Durchlassbereich auf.

Die zweite Messanordnung 5 ist eingerichtet, in einem Störfrequenzbereich zweite elektromagnetische Messsignale zu erfassen. Dazu weist die zweite Messanordnung 5 eine zweite Sensoreinheit 17 und ein zweites Frequenzfilter 19 auf. Die zweite Sensoreinheit 17 weist eine außerhalb der elektrischen Maschine angeordnete zweite Antenne 21 und eine zweite Auskoppeleinheit 23 zum Auskoppeln von der zweiten Antenne 21 erfasster Signale auf. Die zweite Antenne 21 wird beispielsweise von Zuleitungen eines zweiten Temperatursensors gebildet, welcher zum Erfassen einer Umgebungstemperatur in einer Umgebung der elektrischen Maschine eingerichtet ist und dazu einen temperaturabhängigen Messwiderstand aufweist, der beispielsweise aus Platin hergestellt ist, beispielsweise einen Platin-Messwiderstand Pt100. Vorzugsweise sind Anschlussleiter der zweiten Antenne 21 ungeschirmt ausgeführt, um möglichst viele Störsignalen zu empfangen. Die zweite Auskoppeleinheit 23 ist beispielsweise eine Frequenzweiche zum Auskoppeln von der zweiten Antenne 21 erfasster hochfrequenter Signale, um diese Signale von niederfrequenten Temperatursignalen zu trennen, die von dem zweiten Temperatursensor erfasst werden. Das zweite Frequenzfilter 19 ist eingerichtet, die von der zweiten Auskoppeleinheit 23 ausgekoppelten elektrischen Signale zu filtern, und weist einen den Störfrequenzbereich definierenden Durchlassbereich auf. Der Störfrequenzbereich und der Teilentladungsfrequenzbereich weisen beispielsweise eine nichtleere Schnittmenge auf. Insbesondere kann der Störfrequenzbereich den Teilentladungsfrequenzbereich vollständig umfassen. Alternativ kann der Störfrequenzbereich aber auch außerhalb (aber vorzugsweise in der Nähe) des Teilentladungsfrequenzbereichs liegen, denn auch wenn zweite Messsignale nur außerhalb des Teilentladungsfrequenzbereichs erfasst werden, können Störungen, von denen die zweiten Messsignale verursacht werden, auch Störsignale mit Frequenzen innerhalb des Teilentladungsfrequenzbereichs verursachen. Vorzugsweise ist der Störfrequenzbereich in jedem Fall breitbandiger als der Teilentladungsfrequenzbereich. Der Teilentladungsfrequenzbereich und/oder der Störfrequenzbereich können ferner nicht zusammenhängende Teilfrequenzbereiche aufweisen, um Teilentladungen und/oder Störsignale in unterschiedlichen Frequenzbereichen zu erfassen.

In alternativen Ausführungsbeispielen der Vorrichtung 1 weisen die erste Sensoreinheit 9 und/oder die zweite Sensoreinheit 17 statt einer Antenne 13, 21 einen anderen Sensor zum Erfassen elektromagnetischer Signale auf, beispielsweise eine kapazitive Kopplungsvorrichtung, welche mindestens einen Koppelkondensator aufweist, eine induktive Kopplungsvorrichtung, welche mindestens eine Koppelspule aufweist, oder einen Richtkoppler.

Die Auswerteeinheit 7 weist zwei Hochfrequenz-Detektorschaltungen 25, 27 und eine Recheneinheit 29 auf. Eine erste Detektorschaltung 25 ist eingerichtet, aus den von dem ersten Frequenzfilter 11 ausgegebenen ersten Messsignalen erste Amplitudensignale für Amplituden von Spektralanteilen der ersten Messsignale in Abhängigkeit von einer Frequenz der Spektralanteile zu ermitteln. Die zweite Detektorschaltung 27 ist eingerichtet, aus den von dem zweiten Frequenzfilter 19 ausgegebenen zweiten Messsignalen zweite Amplitudensignale für Amplituden von Spektralanteilen der zweiten Messsignale in Abhängigkeit von einer Frequenz der Spektralanteile zu ermitteln. Beispielsweise sind die von den Detektorschaltungen 25, 27 ermittelten Amplitudensignale jeweils Hüllkurvensignale, die zu logarithmierten Amplituden von Spektralkomponenten der Ausgangssignale des jeweiligen Frequenzfilters 11, 19 proportional sind.

Die Recheneinheit 29 umfasst zwei Analog-Digital-Umsetzer 31, 33, zwei Timer 35, 37, zwei Ereignisspeichereinheiten 39, 41 und einen Mikrocontroller 43.

Ein erster Analog-Digital-Umsetzer 31 digitalisiert die von der ersten Detektorschaltung 25 ausgegebenen ersten Amplitudensignale. Der zweite Analog-Digital-Umsetzer 33 digitalisiert die von der zweiten Detektorschaltung 27 ausgegebenen zweiten Amplitudensignale.

Ein erster Timer 35 ermittelt die Zeitpunkte der Erfassung erster Messsignale und die jeweilige Signaldauer eines ersten Messsignals. Der zweite Timer 37 ermittelt die Zeitpunkte der Erfassung zweiter Messsignale und die jeweilige Signaldauer eines zweiten Messsignals. Statt zwei Timern 35, 37 kann alternativ auch ein mehrkanaliger Timer verwendet werden, wobei die ersten und zweiten Messsignale verschiedenen Kanälen des Timers zugeordnet werden.

Eine erste Ereignisspeichereinheit 39 speichert die von dem ersten Analog-Digital-Umsetzer 31 digitalisierten ersten Amplitudensignale und die zugehörigen von dem ersten Timer 35 erfassten Zeitpunkte und Signaldauern. Die zweite Ereignisspeichereinheit 41 speichert die von dem zweiten Analog-Digital-Umsetzer 33 digitalisierten zweiten Amplitudensignale und die zugehörigen von dem zweiten Timer 37 erfassten Zeitpunkte und Signaldauern.

Von dem Mikrocontroller 43 werden die von den Detektorschaltungen 25, 27 digitalisierten Amplitudensignale ausgewertet. Insbesondere wird von dem Mikrocontroller 43 geprüft, ob das digitalisierte erste Amplitudensignal eines ersten Messsignals ein vorgegebenes Erkennungskriterium für ein Teilentladungssignal erfüllt, und ob in einem vorgegebenen Zeitfenster um ein erstes Messsignal ein zweites Messsignal erfasst wird, dessen digitalisiertes zweites Amplitudensignal ein vorgegebenes Störsignalkriterium erfüllt. Ferner ist der Mikrocontroller 43 eingerichtet, die digitalisierten Amplitudensignale eines ersten Messsignals und eines zweiten Messsignals miteinander zu vergleichen, wenn das zweite Messsignal in dem vorgegebenen Zeitfenster um das erste Messsignal erfasst wird, das digitalisierte erste Amplitudensignal des ersten Messsignals das Erkennungskriterium erfüllt und das digitalisierte zweite Amplitudensignal des zweiten Messsignals das Störsignalkriterium erfüllt. Weitere Aspekte der Auswertung der ersten und zweiten Messsignale werden unten anhand eines Ausführungsbeispiels eines erfindungsgemäßen Verfahrens beschrieben. Statt eines Mikrocontrollers 43 kann die Recheneinheit 29 beispielsweise ein FPGA (Field Programmable Gate Array) oder eine andere zum Auswerten der digitalisierten Amplitudensignale geeignete Verarbeitungseinheit aufweisen.

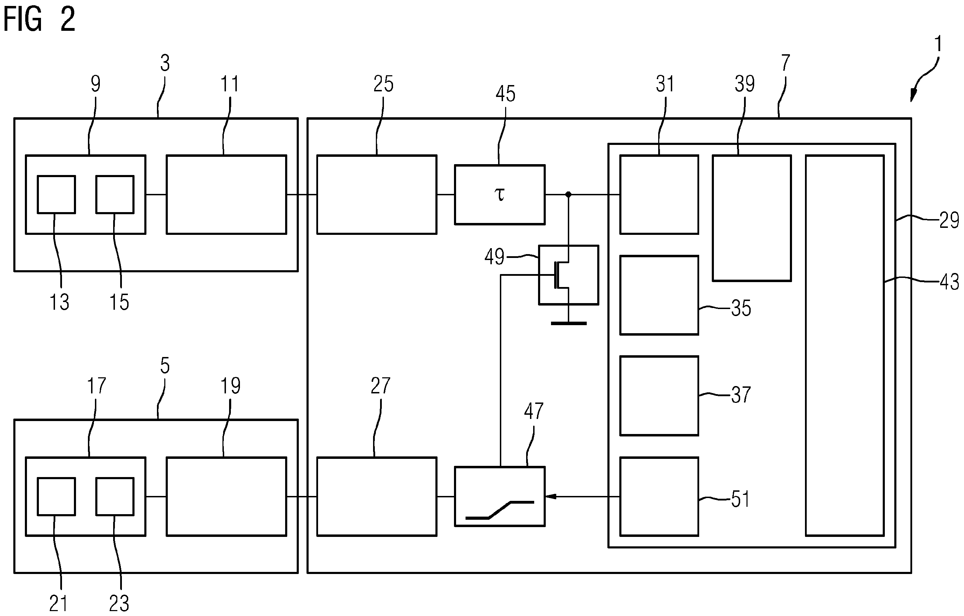

FIG 2 zeigt ein Blockdiagramm eines zweiten Ausführungsbeispiels einer Vorrichtung 1 zum Erfassen einer Teilentladung an einer Wicklung einer elektrischen Maschine. Dieses Ausführungsbeispiel unterscheidet sich von dem in FIG 1 gezeigten Ausführungsbeispiel dadurch, dass die Auswerteeinheit 7 zusätzlich ein Verzögerungsglied 45, einen Schwellenwertdetektor 47 und eine Schalteinheit 49 aufweist, und dass die Recheneinheit 29 statt des zweiten Analog-Digital-Umsetzers 33 und der zweiten Ereignisspeichereinheit 41 einen Digital-Analog-Umsetzer 51 aufweist.

Das Verzögerungsglied 45 ist zwischen die erste Detektorschaltung 25 und den Analog-Digital-Umsetzer 31 geschaltet und verzögert die Weiterleitung der von der ersten Detektorschaltung 25 ausgegebenen ersten Amplitudensignale an den Analog-Digital-Umsetzer 31 um eine Verzögerungszeit τ.

Der Digital-Analog-Umsetzer 51 wandelt einen als ein digitales Signal vorgegebenen Schwellenwert für eine Signalstärke eines zweiten Messsignals in ein analoges Schwellenwertsignal um und gibt dieses Schwellenwertsignal an den Schwellenwertdetektor 47 aus. Der Schwellenwertdetektor 47 vergleicht das von der zweiten Detektorschaltung 27 ausgegebene zweite Amplitudensignal eines zweiten Messsignals mit dem Schwellenwertsignal. Wenn das zweite Amplitudensignal das Schwellenwertsignal überschreitet, aktiviert der Schwellenwertdetektor 47 die Schalteinheit 49, die daraufhin die Ausgabe erster Amplitudensignale durch das Verzögerungsglied 45 an die Recheneinheit 29 unterbricht, indem sie den Ausgang des Verzögerungsglieds 45 mit einem Erdpotential verbindet.

Die Verzögerungszeit τ berücksichtigt dabei unterschiedliche Signallauf- und Verarbeitungszeiten der ersten und zweiten Messsignale, insbesondere auch die von dem Schwellenwertdetektor 47 benötigte Zeit zum Vergleich des zweiten Amplitudensignals mit dem Schwellenwertsignal und die für die Aktivierung der Schalteinheit 49 benötigte Schaltzeit.

Der Schwellenwert kann, beispielsweise über den Mikrocontroller 43, verändert und dadurch sich ändernden Umständen und Anforderungen angepasst werden. Dadurch kann die Empfindlichkeit der Vorrichtung 1 für Störsignalstärken flexibel variiert werden. Über den Schwellenwert kann insbesondere auch eine Unterdrückung von Störsignalen abgeschaltet werden, indem beispielsweise ein sehr hoher Schwellenwert eingestellt wird.

Für die Unterbrechung der Auswertung der ersten Messsignale durch die Aktivierung der Schalteinheit 49 wird beispielsweise eine Unterbrechungszeit vorgegeben, nach deren Ablauf die Schalteinheit 49 wieder deaktiviert wird, oder die Auswertung der ersten Messsignale wird durch Deaktivierung der Schalteinheit 49 fortgesetzt, sobald das zweite Amplitudensignal wieder unter das Schwellenwertsignal fällt oder nachdem eine vorgegebene Zeitdauer nach dem Unterschreiten des Schwellenwertsignals durch das zweite Amplitudensignal verstrichen ist.

Bei dem in FIG 2 gezeigten Ausführungsbeispiel werden von dem Mikrocontroller 43 nur die ersten Amplitudensignale der ersten Messsignale ausgewertet, indem jeweils geprüft wird, ob das erste Amplitudensignal eines ersten Messsignals das vorgegebene Erkennungskriterium erfüllt.

Die in den Figuren 1 und 2 gezeigten Ausführungsbeispiele können auch kombiniert werden, beispielsweise indem das in FIG 1 gezeigte erste Ausführungsbeispiel durch ein Verzögerungsglied 45, einen Schwellenwertdetektor 47, eine Schalteinheit 49 und einen Digital-Analog-Umsetzer 51 analog zu dem in FIG 2 gezeigten zweiten Ausführungsbeispiel erweitert wird. Wie in dem zweiten Ausführungsbeispiel wird die Auswertung der ersten Amplitudensignale durch Aktivierung der Schalteinheit 49 unterbrochen, wenn das zweite Amplitudensignal das Schwellenwertsignal überschreitet, aber die ersten und zweiten Amplitudensignale werden wie in dem ersten Ausführungsbeispiel durch die Analog-Digital-Umsetzer 31, 33 verarbeitet und von dem Mikrocontroller 43 ausgewertet, wenn die Schalteinheit 49 deaktiviert ist, d.h. wenn das zweite Amplitudensignal unter dem Schwellenwertsignal liegt.

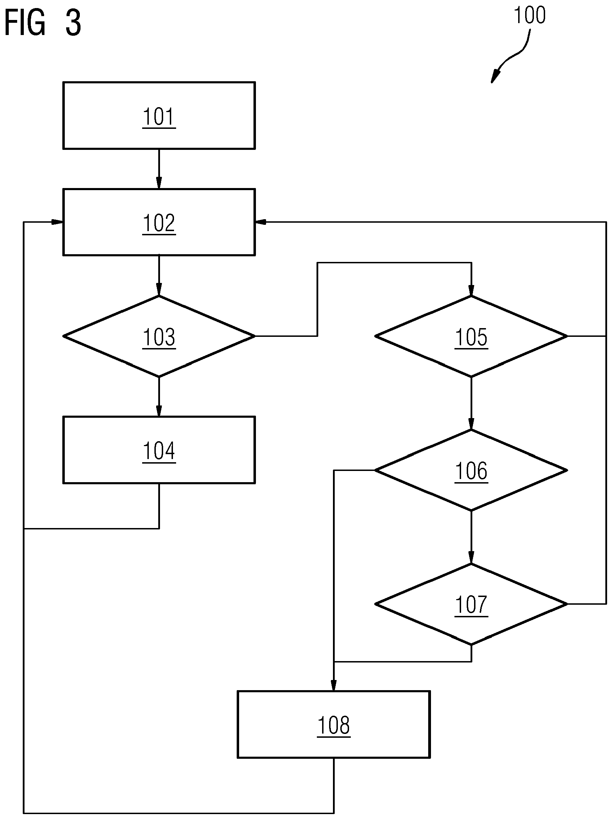

FIG 3 zeigt ein Ablaufdiagramm 100 eines Ausführungsbeispiels des erfindungsgemäßen Verfahrens zum Erfassen einer Teilentladung mit Verfahrensschritten 101 bis 108.

In einem ersten Verfahrensschritt 101 werden ein Erkennungskriterium für ein Teilentladungssignal, ein Störsignalkriterium für ein zweites Messsignal und ein Unterscheidungskriterium zum Unterscheiden eines ersten Messsignals von einem zweiten Messsignal definiert.

Das Erkennungskriterium umfasst beispielsweise wenigstens ein Merkmal eines ersten Amplitudensignals für Amplituden von Spektralanteilen eines ersten Messsignals in Abhängigkeit von einer Frequenz der Spektralanteile. Derartige Merkmale sind beispielsweise Schranken für eine Pulsdauer und/oder eine Pegelhöhe des ersten Amplitudensignals und/oder ein die Signalform charakterisierendes Merkmal (beispielsweise eine Schranke für ein Verhältnis einer Pegelhöhe zu einer Pulsdauer).

Das Störsignalkriterium umfasst einen Schwellenwert für eine Signalstärke eines zweiten Messsignals. Ferner kann das Störsignalkriterium wenigstens ein Merkmal eines zweiten Amplitudensignals für Amplituden von Spektralanteilen eines zweiten Messsignals in Abhängigkeit von einer Frequenz der Spektralanteile umfassen. Derartige Merkmale sind beispielsweise analog zu dem Erkennungskriterium ein die Signalform charakterisierendes Merkmal, und/oder Schranken für eine Pulsdauer und/oder eine Pegelhöhe des zweiten Amplitudensignals. Des Weiteren kann geprüft werden, ob zweite Messsignale eine Signalfolge sich regelmäßig wiederholender, insbesondere in gleichen Zeitabständen aufeinander folgender gleichartiger Signale bilden, und das Störsignalkriterium kann die Zugehörigkeit eines zweiten Messsignals zu einer derartigen Signalfolge umfassen.

Das Unterscheidungskriterium umfasst beispielsweise wenigstens ein Merkmal, das Amplitudensignale für Amplituden von Spektralanteilen eines ersten Messsignals und eines zweiten Messsignals in Abhängigkeit von einer Frequenz der Spektralanteile voneinander unterscheidet. Alternativ oder zusätzlich kann das Unterscheidungskriterium das Fehlen einer für das zweite Messsignal charakteristischen periodischen Wiederholung des ersten Messsignals umfassen. Nach dem ersten Verfahrensschritt 101 wird ein zweiter Verfahrensschritt 102 ausgeführt.

In dem zweiten Verfahrensschritt 102 werden in einem Teilentladungsfrequenzbereich ein elektromagnetisches erstes Messsignal und in einem vorgegebenen Zeitfenster um das erste Messsignal in einem Störfrequenzbereich ein elektromagnetisches zweites Messsignal erfasst. Nach dem zweiten Verfahrensschritt 102 wird ein dritter Verfahrensschritt 103 ausgeführt.

In dem dritten Verfahrensschritt 103 wird geprüft, ob die Signalstärke des in dem zweiten Verfahrensschritt 102 erfassten zweiten Messsignals den Schwellenwert überschreitet. Wenn dies der Fall ist, wird nach dem dritten Verfahrensschritt 103 ein vierter Verfahrensschritt 104 ausgeführt. Andernfalls wird nach dem dritten Verfahrensschritt 103 ein fünfter Verfahrensschritt 105 ausgeführt.

In dem vierten Verfahrensschritt 104 wird die Auswertung erster Messsignale unterbrochen, beispielsweise für eine vorgegebene Unterbrechungszeit oder bis die Signalstärke des zweiten Messsignals unter den Schwellenwert fällt. Nach dem vierten Verfahrensschritt 104 wird wieder der zweite Verfahrensschritt 102 ausgeführt.

In dem fünften Verfahrensschritt 105 wird geprüft, ob das in dem zweiten Verfahrensschritt 102 erfasste erste Messsignal das Erkennungskriterium für ein Teilentladungssignal erfüllt. Wenn dies der Fall ist, wird nach dem fünften Verfahrensschritt 105 ein sechster Verfahrensschritt 106 ausgeführt. Andernfalls wird nach dem fünften Verfahrensschritt 105 wieder der zweite Verfahrensschritt 102 ausgeführt.

In dem sechsten Verfahrensschritt 106 wird geprüft, ob das in dem zweiten Verfahrensschritt 102 erfasste zweite Messsignal das Störsignalkriterium erfüllt, sofern das Störsignalkriterium wenigstens ein zu dem Schwellenwert alternatives Merkmal für ein zweites Messsignal aufweist. Wenn das Störsignalkriterium kein zu dem Schwellenwert alternatives Merkmal aufweist oder das zweite Messsignal ein zu dem Schwellenwert alternatives Merkmal erfüllt, wird nach dem sechsten Verfahrensschritt 106 ein siebter Verfahrensschritt 107 ausgeführt. Andernfalls wird nach dem sechsten Verfahrensschritt 106 ein achter Verfahrensschritt 108 ausgeführt.

In dem siebten Verfahrensschritt 107 wird geprüft, ob das Unterscheidungskriterium zwischen dem in dem zweiten Verfahrensschritt 102 erfassten ersten Messsignal und dem in dem zweiten Verfahrensschritt 102 erfassten zweiten Messsignal erfüllt ist. Wenn dies der Fall ist, wird nach dem siebten Verfahrensschritt 107 der achte Verfahrensschritt 108 ausgeführt. Andernfalls wird nach dem siebten Verfahrensschritt 107 wieder der zweite Verfahrensschritt 102 ausgeführt.

In dem achten Verfahrensschritt 108 wird auf eine Teilentladung geschlossen. Ferner wird vorzugsweise der Wert einer Zählvariablen für erkannte Teilentladungen, die beispielsweise in der Recheneinheit 29 angelegt ist, um Eins inkrementiert und ein Zeitpunkt der Teilentladung gespeichert. Nach dem achten Verfahrensschritt 108 wird wieder der zweite Verfahrensschritt 102 ausgeführt.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren zum Erfassen einer Teilentladung an einer Wicklung einer elektrischen Maschine, wobei
- in einem Teilentladungsfrequenzbereich elektromagnetische erste Messsignale erfasst werden,
- in einem Störfrequenzbereich elektromagnetische zweite Messsignale erfasst werden,
- ein Zeitfenster um ein erstes Messsignal vorgegeben wird,
- ein Erkennungskriterium für ein Teilentladungssignal definiert wird,
- ein Störsignalkriterium für ein zweites Messsignal definiert wird,
- auf eine Teilentladung geschlossen wird, wenn ein erstes Messsignal erfasst wird, das das Erkennungskriterium erfüllt, und in dem Zeitfenster um das erste Messsignal kein zweites Messsignal erfasst wird, das das Störsignalkriterium erfüllt, und
- anhand eines Kennwertes zweiter Messsignale die Teilentladungserfassung bewertet wird, wobei die Bewertung der Teilentladungserfassung hinsichtlich ihrer Güte erfolgt, **dadurch gekennzeichnet, dass** die Güte der Teilentladungserfassung umso schlechter eingestuft wird, je größer die Häufigkeit und/oder Stärke mit den ersten Messsignalen zeitlich korrelierter zweiter Messsignale ist.

2. Verfahren nach Anspruch 1, wobei das Erkennungskriterium wenigstens ein Merkmal eines Amplitudensignals für Amplituden von Spektralanteilen eines ersten Messsignals in Abhängigkeit von einer Frequenz der Spektralanteile umfasst, wobei das Störsignalkriterium wenigstens ein Merkmal eines Amplitudensignals für Amplituden von Spektralanteilen eines zweiten Messsignals in Abhängigkeit von einer Frequenz der Spektralanteile umfasst.

3. Verfahren nach einem der vorhergehenden Ansprüche, wobei geprüft wird, ob zweite Messsignale eine Signalfolge sich regelmäßig wiederholender gleichartiger Signale bilden, und das Störsignalkriterium die Zugehörigkeit eines zweiten Messsignals zu einer derartigen Signalfolge umfasst.

4. Verfahren nach einem der vorhergehenden Ansprüche, wobei der Teilentladungsfrequenzbereich und der Störfrequenzbereich eine nichtleere Schnittmenge aufweisen.

5. Verfahren nach einem der vorhergehenden Ansprüche, wobei wenigstens eine Teilmenge der ersten Messsignale in oder an einer Isolation der Wicklung der elektrischen Maschine erfasst wird.

6. Verfahren nach einem der vorhergehenden Ansprüche, wobei wenigstens eine Teilmenge der zweiten Messsignale außerhalb der elektrischen Maschine, insbesondere in der Nähe einer zweite Messsignale potentiell erzeugenden Störquelle, erfasst wird.

7. Verfahren nach einem der vorhergehenden Ansprüche, wobei ein Unterscheidungskriterium zum Unterscheiden eines ersten Messsignals von einem zweiten Messsignal definiert wird und im Fall, dass in dem Zeitfenster um ein erstes Messsignal, das das Erkennungskriterium erfüllt, ein zweites Messsignal, das das Störsignalkriterium erfüllt, erfasst wird, das erste Messsignal mit dem zweiten Messsignal verglichen wird und nur dann auf eine Teilentladung geschlossen wird, wenn das erste Messsignal das Unterscheidungskriterium erfüllt.

8. Verfahren nach Anspruch 7, wobei das Unterscheidungskriterium wenigstens ein Merkmal umfasst, das Amplitudensignale für Amplituden von Spektralanteilen eines ersten Messsignals und eines zweiten Messsignals in Abhängigkeit von einer Frequenz der Spektralanteile voneinander unterscheidet.

9. Verfahren nach Anspruch 7 oder 8, wobei das Unterscheidungskriterium das Fehlen einer periodischen Wiederholung des ersten Messsignals umfasst, die für das zweite Messsignal charakteristisch ist.

10. Verfahren nach einem der vorhergehenden Ansprüche, wobei das Störsignalkriterium einen Schwellenwert für eine Signalstärke eines zweiten Messsignals umfasst und die Auswertung von ersten Messsignalen unterbrochen wird, wenn die Signalstärke eines zweiten Messsignals den Schwellenwert überschreitet.

11. Vorrichtung (1) eingerichtet zum Erfassen einer Teilentladung an einer Wicklung einer elektrischen Maschine gemäß dem Verfahren nach einem der vorhergehenden Ansprüche, die Vorrichtung (1) umfassend
- eine erste Messanordnung (3), die eingerichtet ist, die ersten elektromagnetischen Messsignale zu erfassen,
- eine zweite Messanordnung (5), die eingerichtet ist, die zweiten elektromagnetischen Messsignale zu erfassen, und
- wenigstens eine Auswerteeinheit (7), die eingerichtet ist, zu prüfen, ob ein erstes Messsignal das Erkennungskriterium für ein Teilentladungssignal erfüllt, und ob in dem vorgegebenen Zeitfenster um ein erstes Messsignal ein zweites Messsignal erfasst wird, das das Störsignalkriterium erfüllt.

12. Vorrichtung (1) nach Anspruch 11, wobei die erste Messanordnung (3) wenigstens eine in oder an einer Isolation der Wicklung der elektrischen Maschine anordenbare erste Antenne (13) und für jede erste Antenne (13) eine erste Auskoppeleinheit (15) zum Auskoppeln von der ersten Antenne (13) erfasster Signale aufweist.

13. Vorrichtung (1) nach Anspruch 11 oder 12, wobei die zweite Messanordnung (5) wenigstens eine außerhalb der elektrischen Maschine, insbesondere in der Nähe einer zweite Messsignale potentiell erzeugenden Störquelle, anordenbarezweite Antenne (21) und für jede zweite Antenne (21) eine zweite Auskoppeleinheit (23) zum Auskoppeln von der zweiten Antenne (21) erfasster Signale aufweist.

14. Vorrichtung (1) nach einem der Ansprüche 11 bis 13, wobei die wenigstens eine Auswerteeinheit (7) eingerichtet ist, im Fall, dass in dem Zeitfenster um ein erstes Messsignal, das das Erkennungskriterium erfüllt, ein zweites Messsignal, das das Störsignalkriterium erfüllt, erfasst wird, das erste Messsignal mit dem zweiten Messsignal auf der Basis eines Unterscheidungskriteriums zu vergleichen.

## Claims

1. Method for detecting a partial discharge at a winding of an electrical machine, wherein
- first electromagnetic measuring signals are detected in a partial discharge frequency range,
- second electromagnetic measuring signals are detected in an interference frequency range,
- a time window around a first measuring signal is predefined,
- an identification criterion is defined for a partial discharge signal,
- an interference signal criterion is defined for a second measuring signal,
- it is concluded that a partial discharge is present if a first measuring signal that meets the identification criterion is detected and no second measuring signal that meets the interference signal criterion is detected in the time window around the first measuring signal, and
- a characteristic value of second measuring signals is used to assess partial discharge detection, wherein the assessing of the partial discharge detection takes place with regard to its quality, **characterised in that** the greater the frequency and/or strength of second measuring signals that are temporally correlated with the first measuring signals, the poorer the classification of the quality of the partial discharge detection.

2. Method according to claim 1, wherein the identification criterion comprises at least one feature of an amplitude signal for amplitudes of spectral components of a first measuring signal as a function of a frequency of the spectral components, wherein the interference signal criterion comprises at least one feature of an amplitude signal for amplitudes of spectral components of a second measuring signal as a function of a frequency of the spectral components.

3. Method according to one of the preceding claims, wherein it is checked whether second measuring signals form a signal sequence of regularly repeating signals of the same type and the interference signal criterion comprises the affiliation of a second measuring signal to a signal sequence of this type.

4. Method according to one of the preceding claims, wherein the partial discharge frequency range and the interference frequency range have a non-empty intersection.

5. Method according to one of the preceding claims, wherein at least one subset of the first measuring signals is detected in or on an insulation of the winding of the electrical machine.

6. Method according to one of the preceding claims, wherein at least one subset of the second measuring signals is detected outside the electrical machine, in particular in the vicinity of an interference source that could potentially generate second measuring signals.

7. Method according to one of the preceding claims, wherein a distinguishing criterion for distinguishing a first measuring signal from a second measuring signal is defined and, in the event of a second measuring signal that meets the interference signal criterion being detected in the time window around a first measuring signal that meets the identification criterion, the first measuring signal is compared with the second measuring signal and it is only concluded that a partial discharge is present if the first measuring signal meets the distinguishing criterion.

8. Method according to claim 7, wherein the distinguishing criterion comprises at least one feature that distinguishes amplitude signals for amplitudes of spectral components of a first measuring signal and a second measuring signal from one another as a function of a frequency of the spectral components.

9. Method according to claim 7 or 8, wherein the distinguishing criterion comprises the absence of a periodic repetition of the first measuring signal that is characteristic of the second measuring signal.

10. Method according to one of the preceding claims, wherein the interference signal criterion comprises a threshold value for a signal strength of a second measuring signal and the evaluation of first measuring signals is interrupted if the signal strength of a second measuring signal exceeds the threshold value.

11. Apparatus (1) configured for detecting a partial discharge at a winding of an electrical machine according to the method according to one of the preceding claims, the apparatus (1) comprising
- a first measuring arrangement (3) configured to detect the first electromagnetic measuring signals,
- a second measuring arrangement (5) configured to detect the second electromagnetic measuring signals, and
- at least one evaluation unit (7) configured to check whether a first measuring signal meets the identification criterion for a partial discharge signal and whether a second measuring signal that meets the interference signal criterion is detected in the predefined time window around a first measuring signal.

12. Apparatus (1) according to claim 11, wherein the first measuring arrangement (3) has at least one first antenna (13) which can be arranged in or on the insulation of the winding of the electrical machine and, for each first antenna (13), a first decoupling unit (15) for decoupling signals detected by the first antenna (13).

13. Apparatus (1) according to claim 11 or 12, wherein the second measuring arrangement (5) has at least one second antenna (21) which can be arranged outside the electrical machine, in particular in the vicinity of an interference source that could potentially generate second measuring signals and, for each second antenna (21), has a second decoupling unit (23) for decoupling signals detected by the second antenna (21).

14. Apparatus (1) according to one of claims 11 to 13, wherein the at least one evaluation unit (7) is configured, in the event of a second measuring signal that meets the interference signal criterion being detected in the time window around a first measuring signal that meets the identification criterion, to compare the first measuring signal with the second measuring signal on the basis of a distinguishing criterion.

## Revendications

1. Procédé de détection d'une décharge partielle sur un enroulement d'une machine électrique, dans lequel
- on détecte des premiers signaux électromagnétiques de mesure dans un domaine de fréquence de décharge partielle,
- on détecte des deuxièmes signaux électromagnétiques de mesure dans un deuxième domaine de fréquence de perturbation,
- on prescrit un créneau temporel autour d'un premier signal de mesure,
- on définit un critère de détection pour un signal de décharge partiel,
- on définit un critère de signal de perturbation pour un deuxième signal de mesure,
- on déduit une décharge partielle, si l'on détecte un premier signal de mesure, qui satisfait le critère de détection et si, dans le créneau temporel autour du premier signal de mesure, on ne détecte pas un deuxième signal de mesure, qui satisfait le critère de signal de perturbation, et
- à l'aide d'une valeur caractéristique de deuxièmes signaux de mesure, on évalue la détection de décharge partielle, dans lequel l'évaluation de la détection de décharge partielle s'effectue en ce qui concerne leur qualité,
**caractérisé en ce que** l'on échelonne la qualité de la détection de décharge partielle comme d'autant moins bonne qu'est plus grande la fréquence et/ou l'intensité de deuxièmes signaux de mesure corrélés dans le temps avec les premiers signaux de mesure.

2. Procédé suivant la revendication 1, dans lequel le critère de détection comprend au moins une caractéristique d'un signal d'amplitude pour des amplitudes de composantes spectrales d'un premier signal de mesure, en fonction d'une fréquence des composantes spectrales, dans lequel le critère de signal de perturbation comprend au moins une caractéristique d'un signal d'amplitude pour des amplitudes de composantes spectrales d'un deuxième signal de mesure, en fonction d'une fréquence des composantes spectrales.

3. Procédé suivant l'une des revendications précédentes, dans lequel on contrôle, si des deuxièmes signaux de mesure forment une succession de signal de même type, se répétant régulièrement, et le critère de signal de perturbation comprend l'appartenance d'un deuxième signal de mesure à une succession de signal de ce genre.

4. Procédé suivant l'une des revendications précédentes, dans lequel le domaine de fréquence de décharge partielle et le domaine de fréquence de perturbation ont une intersection d'ensembles non vide.

5. Procédé suivant l'une des revendications précédentes, dans lequel on détecte au moins un ensemble partiel des premiers signaux de mesure dans ou sur une isolation de l'enroulement de la machine électrique.

6. Procédé suivant l'une des revendications précédentes, dans lequel on détecte au moins un ensemble partiel des deuxièmes signaux de mesure à l'extérieur de la machine électrique, en particulier au voisinage d'une source de perturbation produisant potentiellement des deuxièmes signaux de mesure.

7. Procédé suivant l'une des revendications précédentes, dans lequel on définit un critère de différentiation, pour distinguer un premier signal de mesure d'un deuxième signal de mesure, et dans le cas où, dans le créneau temporel autour d'un premier signal de mesure, qui satisfait le critère de détection, on détecte un deuxième signal de mesure, qui satisfait le critère de signal de perturbation, on compare le premier signal de mesure au deuxième signal de mesure, et on ne déduit une décharge partielle que si le premier signal de mesure satisfait le critère de différentiation.

8. Procédé suivant la revendication 7, dans lequel le critère de différentiation comprend au moins une caractéristique, qui distingue des signaux d'amplitude pour des amplitudes des composantes spectrales d'un premier signal de mesure et d'un deuxième signal de mesure, en fonction d'une fréquence des composantes spectrales.

9. Procédé suivant la revendication 7 ou 8, dans lequel le critère de différentiation comprend l'absence d'une répétition périodique du premier signal de mesure, qui est caractéristique du deuxième signal de mesure.

10. Procédé suivant l'une des revendications précédentes, dans lequel le critère de signal de perturbation comprend une valeur de seuil d'une intensité d'un deuxième signal de mesure et on interrompt l'analyse de premiers signaux de mesure, si l'intensité d'un deuxième signal de mesure dépasse la valeur de seuil.

11. Installation (1) agencée pour la détection d'une décharge partielle sur un enroulement d'une machine électrique selon le procédé suivant l'une des revendications précédentes, l'installation (1) comprenant :
- un premier appareillage (3) de mesure, qui est agencé pour détecter des premiers signaux électromagnétiques de mesure,
- un deuxième appareillage (5) de mesure, qui est agencé pour détecter des deuxièmes signaux électromagnétiques de mesure, et
- au moins une unité (7) d'analyse, qui est agencée pour contrôler, si un premier signal de mesure satisfait le critère de détection d'un signal de décharge partiel et, si dans le créneau temporel donné à l'avance autour d'un premier signal de mesure, on détecte un deuxième signal de mesure, qui satisfait le critère de signal de perturbation.

12. Installation (1) suivant la revendication 11, dans laquelle le premier appareillage (3) de mesure a au moins une première antenne pouvant être mise sur une isolation de l'enroulement de la machine électrique et, pour chaque première antenne (13), une première unité (15) de découplage pour le découplage de signaux détectés par la première antenne (13).

13. Installation (1) suivant la revendication 11 ou 12, dans laquelle le deuxième appareillage (5) de mesure a au moins une deuxième antenne (21) pouvant être montée à l'extérieur de la machine électrique, en particulier à proximité d'une source de perturbation produisant potentiellement des deuxièmes signaux de mesure et, pour chaque deuxième antenne (21), une deuxième unité (23) de découplage pour le découplage de signaux détectés par la deuxième antenne (21).

14. Installation (1) suivant l'une des revendications 11 à 13, dans laquelle la au moins une unité (7) d'analyse est agencée pour, dans le cas où il est détecté, dans le créneau temporel autour d'un premier signal de mesure, qui satisfait le critère de détection, un deuxième signal de mesure, qui satisfait le critère de signal de perturbation, comparer le premier signal de mesure au deuxième signal de mesure, sur la base d'un critère de différentiation.
